# EUROPÄISCHE PATENTSCHRIFT

(11) **EP 1 186 062 B1**
(45) Veröffentlichungstag und Bekanntmachung des Hinweises auf die Patenterteilung: **02.11.2005**
(21) Anmeldenummer: 00929306.9
(22) Anmeldetag: 25.04.2000
(51) Int. Cl.: H01L 41/09

(54) **PIEZOELEKTRISCHER BIEGEWANDLER**
PIEZOELECTRIC FLEXIONAL TRANSDUCER
TRANSDUCTEUR DE FLEXION PIEZO-ELECTRIQUE

(30) Priorität: 04.05.1999 DE 19920576
(43) Veröffentlichungstag der Anmeldung: 13.03.2002
(73) Patentinhaber: Argillon GmbH, 96257 Redwitz (DE)
(72) Erfinder: RIEDEL, Michael, 96472 Rödental (DE)
(74) Vertreter: Tergau & Pohl Patentanwälte
(86) Internationale Anmeldenummer: PCT/DE2000/001272
(87) Internationale Veröffentlichungsnummer: WO 2000/067333

(56) Entgegenhaltungen:
- DE-A- 19 620 826
- DE-C- 19 624 204
- YANG H H: "Kevlar Aramid Fiber" 1993 , JOHN WILEY & SONS , CHICHESTER, UK, ISBN 0 471 93765 7, XP002145060 200220 Abschnitt 2.8 "Tensile properties" Seite 26 -Seite 37 Abschnitt 2.18 "Dimensional stability" Seite 59 -Seite 61 L: Material properties

## Beschreibung

Die Erfindung bezieht sich auf einen piezoelektrischen Biegewandler mit einem Träger aus einem mit Fasern verstärkten Duroplasten und mit einer zumindest einseitig auf dem Träger thermisch aufgeklebten Beschichtung aus einer Piezokeramik.

Ein derartiger Biegewandler ist beispielsweise aus der EP 0 542 772 B1, der DE 196 20 826 B2 und der DE 30 46 535 A1 bekannt. Als Fasermaterial wird in der EP 0 542 772 B1 und der DE 30 46 535 A1 Graphit genannt. In der DE 196 20 826 C2 wird als weiteres Fasermaterial Glas angegeben. Die Piezokeramik ist beispielsweise eine Blei-Zirkonat-Titan-Keramik.

Ein piezoelektrischer Biegewandler der eingangs genannten Art dient vorrangig zur Ausnutzung des indirekten oder reziproken piezoelektrischen Effekts, d.h. zur Umwandlung von elektrischer in mechanische Energie. Für einen Biegewandler gibt es eine Vielzahl von technischen Anwendungen. Solche Anwendungen sind z.B. als piezoelektrischer Druckkopf für einen Tintenstrahldrucker, als Schallaufnehmer oder -erzeuger für Mikrophone bzw. Lautsprecher, als Sensor für die Beschleunigungs- oder Druckmessung, als Stellelement in Braille-Zeilen in Lesegeräten für Blinde, in Textilmaschinen, in Pneumatikventilen, in schreibenden Meßgeräten oder in berührungslosen Oberflächenmeßinstrumenten.

Gemäß der EP 0 455 342 B1 und der EP 0 468 796 A1 wird ein Biegewandler in einer Schichtstruktur aufgebaut. Die Piezokeramik wird dabei zur Verbesserung der mechanischen Stabilität oder zum Zwecke einer besseren Umsetzung von elektrischer in mechanische Energie auf einen Träger aufgebracht. Für die elektrische Kontaktierung wird die Piezokeramik gegebenenfalls beidseitig mit Elektroden in Form einer flächigen Belegung aus einem leitfähigen Material versehen.

Je nach Anwendung kann der Träger ein- oder zweiseitig mit der beschriebenen Schichtabfolge versehen sein. Gemäß der DE 34 34 726 C2 können auch mehrere Lagen von Piezokeramiken einschließlich der Elektroden übereinandergestapelt sein. Je nach Anzahl der Piezokeramik-Schichten spricht man von einem mono-, bi-, tri-, etc. oder allgemein von einem multimorphen piezoelektrischen Biegewandler.

Piezoelektrische Biegewandler mit jeweils einem elektrisch isolierenden Träger finden sich in der DE 43 27 265 C1 und der DE 40 25 436 A1. Durch die Verwendung eines elektrisch isolierenden Trägers lassen sich bei einem bimorphen piezoelektrischen Biegewandler die dem Träger zugewandten Seiten der Piezokeramiken oder die sich darauf befindlichen inneren Elektroden auf unterschiedliches Potential legen. Dadurch kann die Ansteuerung des Biegewandlers ausschließlich über die innenliegenden, durch den Träger gegeneinander isolierten Seiten der inneren Elektroden erfolgen, während die äußeren Elektroden auf Null-Potential oder Masse gelegt sind. Durch diese Maßnahme wird ein derartiger piezoelektrischer Biegewandler berührungssicher.

Die Verwendung eines mit Fasern verstärkten Duroplasten als Trägermaterial bietet den Vorteil einer leichten und problemlosen Verarbeitung. Der Duroplast kann beispielsweise in Form eines sogenannten Prepregs (noch nicht ausgehärteter, weicher, vorimprägnierte Fasern enthaltender Rohling) verarbeitet werden. Das Prepreg wird zusammen mit den Piezokeramiken locker in eine entsprechende Form gelegt. Durch leichtes Pressen benetzt das Prepreg die Oberflächen der Piezokeramiken bzw. der darauf aufgebrachten Elektroden und verklebt dabei damit. Durch eine abschließende Wärmebehandlung härtet das Prepreg dann irreversibel zu dem Duroplasten aus, und man erhält auf einfache Art und Weise eine dauerhafte und stabile Verbindung der Komponenten des Biegewandlers. Wird ein Träger aus Metall eingesetzt, so ergeben sich massive Schwierigkeiten beim Aufbau des Biegewandlers. So ist vor allem das Ablängen eines solchen Biegewandlers aufgrund der Materialpaarung Piezokeramik-Metall mit größten Problemen verbunden. Die Probleme treten bei der Verwendung eines mit Fasern verstärkten Duroplasten nicht auf.

Wird ein berührungssicherer Biegewandler gefordert, so scheidet als Fasermaterial Graphit aufgrund seiner elektrischen Leitfähigkeit aus. Hier muß daher auf Glas und damit für den Träger auf einen mit Glasfasern verstärkten Duroplasten zurückgegriffen werden. Man erhält mit Glasfasern jedoch eine begrenzte Auslenkung des Biegewandlers. Ein Biegewandler mit einem Träger aus einem mit Glasfasern verstärkten Duroplasten zeigt bei gleicher Betriebsspannung eine geringere Auslenkung als ein Biegewandler mit einem Träger aus einem mit Graphitfasern verstärkten Kunststoff.

Aus DE 196 24 204 C1 sowie aus DE 196 20 826 A1 ist jeweils ein Tragkörper zu entnehmen, der zur Versteifung und Verstärung faserverstärkt ist.

Aufgabe der Erfindung ist es, einen piezoelektrischen Biegewandler der eingangs genannten Art anzugeben, welcher gegenüber vergleichbaren Biegewandlern des Standes der Technik mit Trägern aus einem mit Fasern verstärkten Duroplasten ein verbessertes Auslenkvermögen zeigt.

Diese Aufgabe wird für einen Biegewandler der eingangs genannten Art erfindungsgemäß durch die Merkmale des Anspruchs 1 gelöst.

Die Erfindung geht dabei von der Überlegung aus, daß das bessere Auslenkvermögen eines Biegewandlers mit einem Träger aus einem mit Graphitfasern verstärkten Duroplasten gegenüber einem Biegewandler mit einem Träger aus einem mit Glasfasern verstärkten Duroplasten mit dem Wärmeausdehnungskoeffizienten des Fasermaterials zu tun hat. So zeigt Glas einen Wärmeausdehnungskoeffizienten zwischen 5 und 6 · 10⁻⁶/K. Graphit hingegen zeigt einen Wärmeausdehnungskoeffizienten von etwa -0,5 · 10⁻⁶/K. Während Glas also einen positiven Wärmeausdehnungskoeffizienten aufweist, zeigt Graphit einen negativen Wärmeausdehnungskoeffizient.

Weiter geht die Erfindung von der Überlegung aus, daß bei der Herstellung eines piezoelektrischen Biegewandlers mit einem Träger aus einem mit Fasern verstärkten Duroplasten in der Regel ein Prepreg verwendet wird. Der Träger wird wie eingangs erwähnt mit der Piezokeramik dauerhaft dadurch verbunden, daß das Prepreg auf die Piezokeramik gelegt und anschließend durch Druck verpreßt und bei einer Wärmebehandlung unter Aushärtung des Duroplasten thermisch verklebt wird. Da die Piezokeramik senkrecht zur Polarisationsrichtung einen positiven Temperaturgang aufweist, wird bei Verwendung von Fasern mit einem negativen Temperaturgang die Piezokeramik während der Wärmebehandlung gewissermaßen vorgespannt. Die Vorspannung der Piezokeramik bleibt auch nach der Wärmebehandlung erhalten, da der Duroplast hierbei aushärtet. Erste Untersuchungen lassen vermuten, daß die durch die Vorspannung bewirkte Verzerrung der Gitterstruktur der Piezokeramik polarisationsunterstützend wirkt. Die mit dem Träger thermisch verklebte Piezokeramik zeigt bei gleicher Betriebsspannung eine höhere Längenausdehnung bzw. -kontraktion als die nicht mit einem solchen Träger verklebte Piezokeramik.

Aufgrund der unidirektionalen Ausrichtung der Fasern parallel zu einer vorgegebenen Längsrichtung des Trägers ergibt sich beim thermischen Verkleben des Prepregs mit den Piezokeramikschichten eine Kontraktion des Trägers in Längsrichtung. Die Piezokeramik der Schichten ist also in Richtung ihrer Ausdehnung oder Kontraktion bei Anlegen eines elektrischen Feldes an die Elektroden vorgespannt. Durch die unidirektionale Ausrichtung wird zudem das.größte Elastizitätsmodul des Trägers in Längsrichtung erzielt. Quereffekte können im wesentlichen vernachlässigt werden.

Ein besonders hohes Auslenkvermögen des piezoelektrischen Biegewandlers läßt sich erzielten, wenn das Fasermaterial einen Wärmeausdehnungskoeffizienten von weniger als -3 · 10⁻⁶/K zeigt.

Als Piezokeramiken eignen sich prinzipiell alle Keramiken, die gegebenenfalls nach Polarisation in einem elektrischen Feld den piezoelektrischen Effekt zeigen. Insbesondere eignet sich natürlich eine Blei-Zirkonat-Titan-Oxidkeramik, die über ihre Zusammensetzung eine Anpassung an unterschiedliche Anforderungen erlaubt. Durch Anlegen eines homogenen elektrischen Feldes wird eine polare Achse in der Piezokeramik erzeugt, die für das Auftreten des piezoelektrischen Effekts notwendig ist.

Als Fasermaterial sind prinzipiell alle Materialien geeignet, die zum einen eine Verstärkung des verwendeten Duroplasten ermöglichen und zum anderen den geforderten Wärmeausdehnungskoeffizienten aufweisen. Vorteilhafterweise wird als Fasermaterial jedoch Polyamid verwendet. Eine Reihe von Polyamiden zeichnet sich durch eine hohe Festigkeit, Elastizität und gute Formstabilität aus.

In besonders vorteilhafter Ausgestaltung der Erfindung handelt es sich bei dem Polyamid um ein Aramid, d.h. um ein aromatisches Polyamid. Vertreter der Gruppe der Aramide haben neben einer hohen Festigkeit und Elastizität sowie einer guten Formstabilität eine hohe thermische Beständigkeit und zeichnen sich zudem durch eine niedrige Dehnung aus. Geeignete Aramide sind beispielsweise das von DuPont unter dem Markennamen Kevlar vertriebene Aramid oder das von Akzo Nobel unter dem Markennamen Twaron erhältliche Aramid.

Weiter von Vorteil ist es, wenn das Aramid ein Elastizitätsmodul zwischen 100 und 130 GPa aufweist. Ein solches Aramid ist beispielsweise das von Akzo Nobel vertriebene Aramid mit dem Namen Twaron Typ 1056.

Weitere vorteilhafte Eigenschaften lassen sich erzielen, wenn das Faserflächengewicht im Duroplasten zwischen 100 und 900 g/m² beträgt.

Als Material für den Duroplasten eignet sich vorteilhafterweise ein Epoxidharz. Ein mit Fasern verstärktes Epoxidharz in Gestalt eines Prepregs läßt sich leicht und kostengünstig zu dem piezoelektrischen Biegewandler verarbeiten.

Dabei ist es für die Eigenschaften des Trägers besonders von Vorteil, wenn der Masseanteil des Epoxidharzes im Träger zwischen 40 und 60 % beträgt. Damit wird gleichzeitig eine genügend große Härte und eine genügend hohe Flexibilität erzielt.

Für Anwendungsfälle, in denen ein berührungssicherer piezoelektrischer Biegewandler gefordert ist, ist es von Vorteil, wenn der Träger elektrisch isolierend ist.

Ausführungsbeispiele der Erfindung werden anhand einer Zeichnung sowie anhand eines Beispiels näher erläutert. Dabei zeigt:
- FIG 1: in dreidimensionaler Darstellung den Aufbau eines piezoelektrischen Biegewandlers, und
- FIG 2: in vergrößerter Darstellung einen Schnitt durch einen piezoelektrischen Biegewandler.

Gleiche Teile haben dabei die gleichen Bezugszeichen.

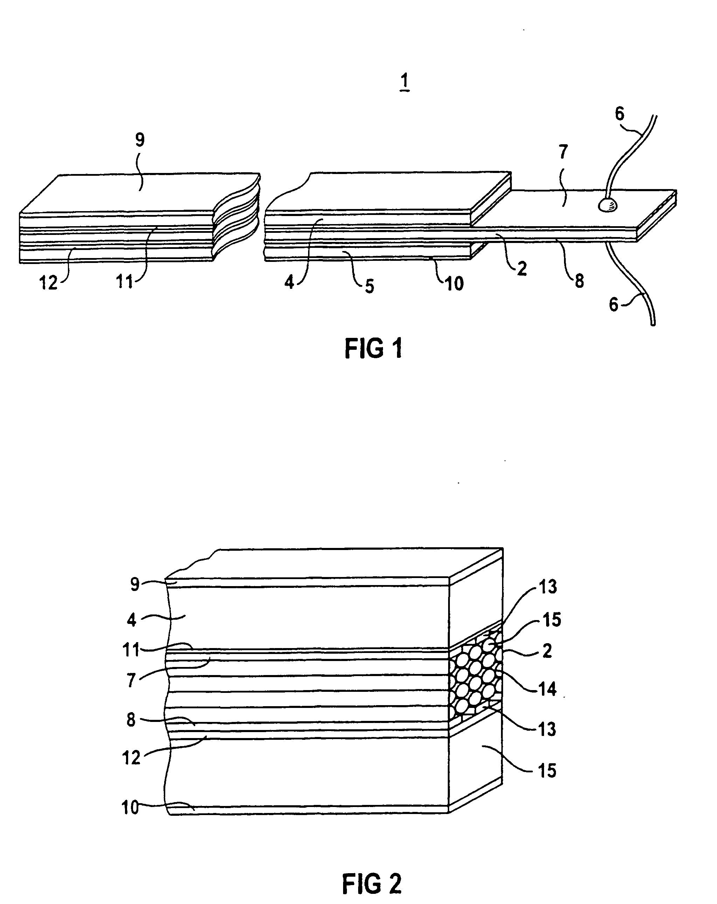

Figur 1 zeigt einen bimorphen Biegewandler 1 mit einem Träger 2 und mit einer darauf aufgebrachten ersten und zweiten Beschichtung 4, 5 aus einer Piezokeramik. Die Piezokeramik ist hierbei eine Blei-Zirkonat-Titan-Oxidkeramik. Der Träger 2 ist ein mit Aramidfasern verstärktes Epoxidharz. Als Fasermaterial wurde das von Akzo Nobel vertriebene Twaron vom Typ 1056 verwendet. Dieses Aramid zeigt einen Wärmeausdehnungskoeffizienten von -3,5 · 10⁻⁶/K. Als Ausgangsmaterial für den Träger wurde ein Epoxidharz-Prepreg verwendet, welches eine flächenbezogene Masse der Aramidfasern von 167,4 g/m² und einen Harzmasseanteil von 46,4 % aufwies. Das Prepreg wurde durch eine Wärmebehandlung mit den Piezokeramikschichten 4, 5 thermisch verklebt und ausgehärtet.

Der Biegewandler 1 weist weiter elektrische Anschlüsse 6 auf, welche jeweils über einen Lötkontakt mit auf dem Träger 2 angeordneten Elektroden 7 und 8 elektrisch verbunden sind. Die Piezokeramikschichten 4 und 5 sind beidseitig flächig mit Elektroden 9, 11 bzw. 10, 12 versehen. Die Elektroden 7 und 8 des Trägers 2 sind, hier nicht näher dargestellt, an den Stellen des Trägers 2, an welchen die Piezokeramikschichten 4 und 5 aufgelegt sind, nicht flächig, sondern als ein Gewebe oder in Form von parallelen Stegen ausgebildet. Bei der Wärmebehandlung des Prepregs fließt deshalb das noch nicht ausgehärtete Epoxidharz durch die Elektroden 7 und 8 auf die Elektroden 11 und 12 und verklebt damit beim Aushärten den Träger 2 über die Elektroden mit den Piezokeramikschichten 4 und 5. Die Elektroden 9, 10, 11, 12 der Piezokeramikschichten 4 und 5 sind jeweils als eine flächige Belegung aus einem Carbonpolymer ausgebildet. Aufgrund des negativen Temperaturganges der Aramidfasern wird die Piezokeramik beim thermischen Verkleben vorgespannt.

In Figur 2 ist in einer vergrößerten Darstellung ein Schnitt durch den in Figur 1 gezeigten Biegewandler 1 dargestellt. Man erkennt wiederum die Piezokeramikschichten 4 und 5 sowie die darauf aufgebrachten Elektroden 9, 11 bzw. 10, 12. Die auf dem Träger 2 aufgebrachten Elektroden 7, 8 sind als sich in Längsrichtung des Trägers 2 erstreckende parallele Stege 13 ausgebildet. Deutlich zu erkennen ist, daß die Aramidfasern 14 unidirektional und in Längsrichtung des Trägers 2 ausgerichtet vorliegen. Auf diese Weise ergibt sich beim thermischen Verkleben des Prepregs mit den Piezokeramikschichten 4, 5 eine Kontraktion des Trägers 2 in Längsrichtung. Die Piezokeramik der Schichten 4, 5 ist also in Richtung ihrer Ausdehnung oder Kontraktion bei Anlegen eines elektrischen Feldes an die Elektroden vorgespannt. Durch die unidirektionale Ausrichtung der Aramidfasern 14 wird zudem das größte Elastizitätsmodul des Trägers 2 in Längsrichtung erzielt. Quereffekte können im wesentlichen vernachlässigt werden.

Bei einem Vergleich des in Figur 1 gezeigten Biegewandlers 1 mit einem im Aufbau identischen Biegewandler, welcher jedoch einen Träger aus einem mit Glasfasern verstärkten Epoxidharz aufwies, wurde bei gleicher Betriebsspannung eine um 60 % höhere Auslenkung gemessen. Als Betriebsspannung wurden 200 V gewählt. Die verglichenen Biegewandler wiesen eine freie Länge von 38 mm und eine Dicke von 0.75 mm auf.

## Patentansprüche

1. Piezoelektrischer Biegewandler (1) mit einem Träger (2) aus einem mit Fasern (14) verstärkten Duroplasten und mit einer zumindest einseitig auf dem Träger (2) thermisch aufgeklebten Beschichtung (4,5) aus einer Piezokeramik, wobei das Fasermaterial einen Wärmeausdehnungskoeffizienten von weniger als -0.5 · 10⁻⁶/K zeigt,
**dadurch gekennzeichnet, daß** sich der Träger (2) in eine Längsrichtung erstreckt und die Fasern unidirektional und parallel zu der Längsrichtung angeordnet sind.

2. Piezoelektrischer Biegewandler (1) nach Anspruch 1, bei
dem das Fasermaterial einen Wärmeausdehnungskoeffizienten von weniger als -3 · 10⁻⁶/K zeigt.

3. Piezoelektrischer Biegewandler (1) nach Anspruch 1 oder 2,
bei das Fasermaterial Polyamid ist.

4. Piezoelektrischer Biegewandler (1) nach Anspruch 3,
bei dem das Polyamid ein Aramid ist.

5. Piezoelektrischer Biegewandler (1) nach Anspruch 4,
bei dem das Aramid ein Elastizitätsmodul zwischen 100 und 130 GPa aufweist.

6. Piezoelektrischer Biegewandler (1) nach einem der vorhergehenden Ansprüche, mit einem Faserflächengewicht, bezogen auf den Duroplasten, zwischen 100 und 900 g/m².

7. Piezoelektrischer Biegewandler (1) nach einem der vorhergehenden Ansprüche, bei dem der Duroplast ein Epoxidharz ist.

8. Piezoelektrischer Biegewandler (1) nach Anspruch 7,
mit einem Masseanteil des Epoxidharzes im Träger (2) zwischen 40 und 60 %.

9. Piezoelektrischer Biegewandler (1) nach einem der vorhergehenden Ansprüche, mit einem elektrisch isolierenden Träger (2).

## Claims

1. Piezoelectric bending transducer (1) with a support (2) consisting of a thermosetting material reinforced with fibres (14) and with a piezoceramic coating (4, 5) thermobonded to at least one side of the support (2), the fibre material exhibiting a coefficient of thermal expansion of less than -0.5 · 10⁻⁶/K, **characterized in that** the support (2) extends in a longitudinal direction and the fibres are arranged unidirectionally and parallel to the longitudinal direction.

2. Piezoelectric bending transducer (1) according to Claim 1, in which the fibre material exhibits a coefficient of thermal expansion of less than -3 · 10⁻⁶/K.

3. Piezoelectric bending transducer (1) according to Claim 1 or 2, in which the fibre material is polyamide.

4. Piezoelectric bending transducer (1) according to Claim 3, in which the polyamide is an aramid.

5. Piezoelectric bending transducer (1) according to Claim 4, in which the aramid has a modulus of elasticity of between 100 and 130 GPa.

6. Piezoelectric bending transducer (1) according to one of the preceding claims, with a weight per unit area of fibres, with respect to the thermosetting material, of between 100 and 900 g/m².

7. Piezoelectric bending transducer (1) according to one of the preceding claims, in which the thermosetting material is an epoxy resin.

8. Piezoelectric bending transducer (1) according to Claim 7, with a proportion by mass of the epoxy resin in the support (2) of between 40 and 60%.

9. Piezoelectric bending transducer (1) according to one of the preceding claims, with an electrically insulated support (2).

## Revendications

1. Transducteur de flexion piézoélectrique (1) muni d'un support (2) en un duroplaste renforcé avec des fibres (14) et muni au moins unilatéralement d'un revêtement (4, 5) piézocéramique thermocollé sur le support (2), dans lequel le matériau fibreux présente un coefficient de dilatation thermique inférieur à -0,5.10⁻⁶/K, **caractérisé en ce que** le support (2) s'étend dans la direction longitudinale et les fibres sont disposées unidirectionnellement et parallèlement à la direction longitudinale.

2. Transducteur de flexion piézoélectrique (1) selon la revendication 1, dans lequel le matériau fibreux présente un coefficient de dilatation thermique inférieur à -3.10⁻⁶/K.

3. Transducteur de flexion piézoélectrique (1) selon la revendication 1 ou 2, dans lequel le matériau fibreux est un polyamide.

4. Transducteur de flexion piézoélectrique (1) selon la revendication 3, dans lequel le polyamide est un aramide.

5. Transducteur de flexion piézoélectrique (1) selon la revendication 4, dans lequel l'aramide présente un module d'élasticité compris entre 100 et 130 GPa.

6. Transducteur de flexion piézoélectrique (1) selon l'une des revendications précédentes, avec un grammage de fibres, par rapport au duroplaste, compris entre 100 et 900 g/m².

7. Transducteur de flexion piézoélectrique (1) selon l'une des revendications précédentes, dans lequel le duroplaste est une résine époxy.

8. Transducteur de flexion piézoélectrique (1) selon la revendication 7, avec un rapport massique de la résine époxy dans le support (2) compris entre 40 et 60 %.

9. Transducteur de flexion piézoélectrique (1) selon l'une des revendications précédentes, muni d'un support électriquement isolant (2).
